# EUROPÄISCHE PATENTSCHRIFT

(11) **EP 3 781 720 B1**
(45) Veröffentlichungstag und Bekanntmachung des Hinweises auf die Patenterteilung: **04.09.2024**
(21) Anmeldenummer: 19717488.1
(22) Anmeldetag: 12.04.2019
(51) Int. Cl.: C23C 14/06, C04B 35/58, C04B 35/645, C23C 14/34

(54) **TARGET UND VERFAHREN ZUR HERSTELLUNG EINES TARGETS**
TARGET AND METHOD FOR PRODUCING A TARGET
CIBLE ET PROCÉDÉ DE FABRICATION D'UNE CIBLE

(30) Priorität: 20.04.2018 AT 5007418 U
(43) Veröffentlichungstag der Anmeldung: 24.02.2021
(73) Patentinhaber: PLANSEE COMPOSITE MATERIALS GMBH, DE-86983 Lechbruck am See (DE)
(72) Erfinder: POLCIK, Peter, 86983 Lechbruck am See (DE)
(74) Vertreter: Torggler & Hofmann Patentanwälte - Innsbruck
(86) Internationale Anmeldenummer: PCT/EP2019/059515
(87) Internationale Veröffentlichungsnummer: WO 2019/201795

(56) Entgegenhaltungen:
- WO-A1-2019/068933
- US-A- 4 259 119
- O.V. SOBOL ET AL: "Peculiarities of structure state and mechanical characteristics in ion-plasma condensates of quasibinary system borides W2B5-TiB2", SCIENCE OF SINTERING, vol. 38, no. 1, 1 January 2006 (2006-01-01), YU, pages 63 - 72, XP055535061, ISSN: 0350-820X, DOI: 10.2298/SOS0601063S
- PAUL H MAYRHOFER ET AL: "High-entropy ceramic thin films; A case study on transition metal diborides", ARXIV.ORG, CORNELL UNIVERSITY LIBRARY, 201 OLIN LIBRARY CORNELL UNIVERSITY ITHACA, NY 14853, 28 February 2018 (2018-02-28), XP081213554, DOI: 10.1016/J.SCRIPTAMAT.2018.02.008
- MORAES V ET AL: "Substoichiometry and tantalum dependent thermal stability of [alpha]-structured W-Ta-B thin films", SCRIPTA MATERIALIA, ELSEVIER, AMSTERDAM, NL, vol. 155, 13 June 2018 (2018-06-13), pages 5 - 10, XP085431399, ISSN: 1359-6462, DOI: 10.1016/J.SCRIPTAMAT.2018.06.005

## Beschreibung

Die vorliegende Erfindung betrifft ein Target (eine Beschichtungsquelle) für die physikalische Dampfphasenabscheidung mit den Merkmalen des Oberbegriffs des Anspruchs 1 und ein Verfahren zur Herstellung eines Targets mit den Merkmalen des Anspruchs 9.

Im Stand der Technik werden in großem Umfang Verfahren der physikalischen Dampfphasenabscheidung zur Herstellung verschiedenster Schichten eingesetzt. Aufgrund des breiten Anwendungsspektrums solcher Schichten müssen verschiedenartige Beschichtungsmaterialien abgeschieden werden können.

Bei der physikalischen Dampfphasenabscheidung kommen dabei verschiedene Techniken zum Einsatz, wie z. B. Verdampfen, Kathodenzerstäubung (sputter deposition) oder Lichtbogenverdampfung (cathodic arc deposition oder Arc-Source-Verdampfungstechnik).

Ein Target ist für die Verwendung in einem PVD (physical vapor deposition, physikalische Dampfabscheidung) Prozess zur Abscheidung von Schichten auf ein dafür vorgesehenes Substratmaterial geeignet. Im Sinne der Erfindung sind unter dem Begriff Target Sputtertargets oder Arc Kathoden zu verstehen.

Die Targets werden je nach Werkstoff durch unterschiedliche Technologien hergestellt. Dabei kann man grundsätzlich zwischen pulver- und schmelzmetallurgischen Prozessen unterscheiden. Bei den pulvermetallurgischen Technologien gibt es viele unterschiedliche Möglichkeiten, die entsprechend der Zusammensetzung des Targets unter Berücksichtigung der Eigenschaften der integrierten Elemente gewählt werden müssen. Beispielhaft sind hier Pressen, Sintern, Heißisostatisches Pressen (HIP), Schmieden, Walzen, Heißpressen (HP) oder Spark Plasma Sintern (SPS) auch in Kombination untereinander zu nennen.

Gattungsgemäße Targets und Verfahren werden beschrieben in WO 2008/96648 A1, JP 05195199, JP55128560 und WO 2011/137472 A1.

Insbesondere beschreibt die JP55128560 die Herstellung eines Sinterkörpers mit mindestens zwei unterschiedlichen Diboriden, wobei zwingend Metalle wie Nickel, Eisen und Kobalt in Form von Boriden als Binder und Sinterhilfsmittel verwendet werden, um den Nachteil der niedrigen Porosität der Herstellung bei verhältnismäßig niedrigen Sintertemperaturen zu kompensieren. Nachteilig ist, dass diese Metalle bei Einsatz eines Sinterkörpers als Targets die Reinheit der abgeschiedenen Schichten beeinträchtigen.

Es ist auch bekannt, Schichten aus Tantaldiborid (TaB₂) und Wolframborid (WB₂ und/oder W₂B₅) mittels Co-Sputtern herzustellen, wobei gesonderte Targets aus im Wesentlichen reinen Tantaldiborid (TaB₂) und im Wesentlichen reinen Wolframborid (WB₂ und/oder W₂B₅) eingesetzt werden. Nachteilig ist, dass bei industriellen Beschichtungsprozessen aufgrund der räumlichen Trennung der gesonderten Targets mit rotierenden Substraten zwangsläufig Multilagenschichten entstehen und keine chemisch homogene Schicht.

Aufgabe der Erfindung ist die Bereitstellung eines gattungsgemäßen Targets und eines gattungsgemäßen Verfahrens zur Herstellung eines Targets, welches eine hohe Dichte aufweist, mit welchem hochreine, chemisch homogene Schichten herstellbar sind und welches eine feine und isotrope Mikrostruktur aufweist.

Diese Aufgabe wird durch ein Target mit den Merkmalen des Anspruchs 1 und ein Verfahren mit den Merkmalen des Anspruchs 9 gelöst. Vorteilhafte Ausführungsformen der Erfindung sind in den abhängigen Ansprüchen definiert. Schutz wird auch begehrt für eine Verwendung eines erfindungsgemäßen Targets in einem physikalischen Gasphasen-Abscheide-Verfahren (PVD) zur Abscheidung von Dünnschichten auf einem Substrat.

Die Erfindung kommt ohne den Einsatz von Bindern oder Sinterhilfsmitteln wie beispielsweise Nickel, Kobalt oder Eisen als pulverförmige Zugaben aus, weil das erfindungsgemäße Verfahren zur Herstellung eines Targets bei verhältnismäßig hohen Temperaturen stattfindet. Dies führt aber zwangsläufig dazu, dass das Gefüge bei diesen hohen Temperaturen sehr stark vergröbern würde, was wiederum nachteilig für den Einsatz als Target wäre. Die Erfindung vermeidet diese Vergröberung, indem ein Pulver aus mindestens zwei unterschiedlichen Phasen, nämlich Tantaldiborid (TaB₂), Wolframborid (WB₂ und/oder W₂B₅), und ggf. Kohlenstoff, vorzugsweise Graphit, (falls der Kohlenstoff nicht in Form einer Verunreinigung einer oder beider der Phasen Tantaldiborid (TaB₂) oder Wolframborid (WB₂ und/oder W₂B₅) vorliegt), zum Einsatz kommt. Dies gewährleistet die Beibehaltung einer feinen Mikrostruktur trotz der verhältnismäßig hohen Verdichtungstemperatur.

Erfindungsgemäß beträgt die Summe aus der Mischung von wenigstens zwei der nachstehenden Verbindungen: Tantaldiborid (TaB₂) und Wolframborid (WB₂ und/oder W₂B₅) und dem Kohlenstoff (C) wenigstens 99,8 mol%. Dabei handelt es sich um die metallische Reinheit ohne Betrachtung solcher Elemente wie Sauerstoff (O), Stickstoff (N) oder Wasserstoff (H).

Ein für das erfindungsgemäße Verfahren verwendbarer Pulveransatz besteht aus:
- 95 mol% bis 100 mol% aus einer Mischung von Tantaldiborid (TaB₂) und Wolframborid (WB₂ und/oder W₂B₅)
- und gegebenenfalls 0,01 mol% bis 5 mol% Kohlenstoff (C)

Aufgrund von Verunreinigungen von Tantaldiborid (TaB₂) und/oder Wolframborid (WB₂ und/oder W₂B₅) können in den erfindungsgemäßen Targets andere Boride als Tantaldiborid (TaB₂) und Wolframborid (WB₂ und/oder W₂B₅) detektierbar sein (weniger als 0,01 mol%).

Bei einem Ausführungsbeispiel der Erfindung ist vorgesehen, dass der Kohlenstoff (C) in Form von Graphit vorliegt.

Für eine Mischung eines Pulveransatzes für Targets mit der Zusammensetzung von TaB₂/W₂B₅ 35/65 mol% sind beispielhaft folgende Pulver verwendet worden:
- TaB₂ mit einem d50 Wert für die Korngröße von 2,5 µm
- WB₂ und/oder W₂B₅ mit einem d50 Wert für die Korngröße von 9,4 µm
- Graphitpulver mit einer Korngröße kleiner 6 µm

Die Pulver sind in einem Verhältnis von TaB₂/W₂B₅ von 35/65 mol% gemischt worden. Die fertig gemahlene Pulvermischung ist durch Heißpressen in Werkzeugen mit dem Durchmesser von 165 mm zu Ronden mit den Abmessungen von dia 165 x 8 mm bei einem Pressdruck von 30 MPa und einer Temperatur von 2000 °C verdichtet worden.

Bei einem Ausführungsbeispiel der Erfindung ist vorgesehen, dass das Tantaldiborid (TaB₂) und/oder Wolframborid (WB₂ und/oder W₂B₅) und/oder Mischphasen von Tantaldiborid (TaB₂) und Wolframborid (WB₂ und/oder W₂B₅) derart homogen verteilt im Target vorliegen, dass bei Auswahl von zumindest fünf quadratischen oder kreisförmigen unterschiedlichen Messbereichen mit einer Größe von jeweils mindestens 1 mm² die an der Oberfläche des jeweiligen Messbereichs ermittelte mittlere chemische Zusammensetzung nicht mehr als 20 %, bevorzugt nicht mehr als 10 %, von einer gemittelten chemischen Zusammensetzung, berechnet aus allen ausgewählten Messbereichen, abweicht.

Bei einem Ausführungsbeispiel der Erfindung ist vorgesehen, dass in einer röntgenografischen Untersuchung des Targets eine isotrope Struktur ohne bevorzugte kristallografische Kornausrichtung erkennbar ist, wobei ein Aspektverhältnis von Körnern der Mischung aus Tantaldiborid (TaB₂) und/oder Wolframborid (WB₂ und/oder W₂B₅) und/oder Mischphasen von Tantaldiborid (TaB₂) und Wolframborid (WB₂ und/oder W₂B₅) kleiner als 1,5, bevorzugt kleiner als 1,2, besonders bevorzugt im Wesentlichen 1, ist.

Bei einem Ausführungsbeispiel der Erfindung ist vorgesehen, dass nur Tantaldiborid (TaB₂) und/oder Wolframborid (WB₂ und/oder W₂B₅) und/oder Mischphasen von Tantaldiborid (TaB₂) und Wolframborid (WB₂ und/oder W₂B₅) in Form von röntgenografisch identifizierbaren Phasen vorliegen.

Bei einem Ausführungsbeispiel der Erfindung ist vorgesehen, dass eine HV30 Vickershärte des Targets größer als 1800 HV30, bevorzugt größer als 2300 HV30 ist.

In Bezug auf das Verfahren ist bei einem Ausführungsbeispiel der Erfindung vorgesehen, dass das Heißpressen oder Spark-Plasma-Sintern (SPS) bei einem Druck von mindestens 20 MPa, bevorzugt mindestens 30 MPa erfolgt.

In Bezug auf das Verfahren ist bei einem Ausführungsbeispiel der Erfindung vorgesehen, dass das Heißpressen oder Spark-Plasma-Sintern (SPS) in einem Vakuum oder in einer inerten Schutzgasatmosphäre erfolgt.

## Patentansprüche

1. Target für die physikalische Dampfphasenabscheidung, mit folgender chemischer Zusammensetzung:
- wenigstens 95 mol% aus einer Mischung von wenigstens zwei der nachstehenden Verbindungen: Tantaldiborid (TaB₂) und/oder Wolframborid und/oder Mischphasen von Tantaldiborid (TaB₂) und Wolframborid
- 0,01 mol% bis 5 mol% Kohlenstoff (C)
- insbesondere weniger als 0,01 mol% andere Boride als Tantaldiborid (TaB₂) und/oder Wolframborid und/oder Mischphasen von Tantaldiborid (TaB₂) und Wolframborid
wobei in Bezug auf die metallische Reinheit die Summe aus der Mischung von Tantaldiborid (TaB₂) und/oder Wolframborid und/oder Mischphasen von Tantaldiborid (TaB₂) und Wolframborid und dem Kohlenstoff (C) wenigstens 99,8 mol% beträgt,
und mit folgenden physikalischen Eigenschaften:
- einer Dichte größer als 90 %, vorzugsweise größer als 95 %, der theoretischen Dichte der oben definierten chemischen Zusammensetzung
- einem d50-Wert als mittlere Korngröße von Körnern der Mischung von Tantaldiborid (TaB₂) und/oder Wolframborid und/oder Mischphasen von Tantaldiborid (TaB₂) und Wolframborid kleiner als 10 µm, vorzugsweise kleiner 3 µm.

2. Target nach Anspruch 1, wobei das molekulare Verhältnis von Tantal (Ta) zu Wolfram (W) in der Mischung von Tantaldiborid (TaB₂) und/oder Wolframborid und/oder Mischphasen von Tantaldiborid (TaB₂) und Wolframborid in einem Bereich liegt von 1:99 bis 99:1, bevorzugt in einem Bereich von 10:90 bis 90:10.

3. Target nach wenigstens einem der vorangehenden Ansprüche, wobei der Kohlenstoff (C) in Form von Graphit vorliegt.

4. Target nach wenigstens einem der vorangehenden Ansprüche, wobei nur Tantaldiborid (TaB₂) und/oder Wolframborid und/oder Mischphasen von Tantaldiborid (TaB₂) und Wolframborid in Form von röntgenografisch identifizierbaren Phasen vorliegen.

5. Target nach wenigstens einem der vorangehenden Ansprüche, wobei das Tantaldiborid (TaB₂) und/oder Wolframborid und/oder Mischphasen von Tantaldiborid (TaB₂) und Wolframborid derart homogen verteilt im Target vorliegen, dass bei Auswahl von zumindest fünf quadratischen oder kreisförmigen unterschiedlichen Messbereichen mit einer Größe von jeweils mindestens 1 mm² die an der Oberfläche des jeweiligen Messbereichs ermittelte mittlere chemische Zusammensetzung nicht mehr als 20 %, bevorzugt nicht mehr als 10 %, von einer gemittelten chemischen Zusammensetzung, berechnet aus allen ausgewählten Messbereichen, abweicht.

6. Target nach wenigstens einem der vorangehenden Ansprüche, wobei in einer röntgenografischen Untersuchung des Targets eine isotrope Struktur ohne bevorzugte kristallografische Kornausrichtung erkennbar ist, wobei ein Aspektverhältnis von Körnern aus Tantaldiborid (TaB₂) und/oder Wolframborid und/oder Mischphasen von Tantaldiborid (TaB₂) und Wolframborid kleiner als 1,5, bevorzugt kleiner als 1,2, besonders bevorzugt im Wesentlichen 1, ist.

7. Target nach wenigstens einem der vorangehenden Ansprüche, wobei gegebenenfalls vorliegende andere chemische Elemente als Tantal (Ta), Wolfram (W), Bor (B) und Kohlenstoff (C) im Gefüge der Mischung von Tantaldiborid (TaB₂) und/oder Wolframborid und/oder Mischphasen von Tantaldiborid (TaB₂) und Wolframborid gelöst sind und nicht als gesonderte Phasen röntgenografisch detektierbar sind.

8. Target nach wenigstens einem der vorangehenden Ansprüche, wobei eine HV30 Vickershärte des Targets größer als 1800 HV30, bevorzugt größer als 2300 HV30 ist.

9. Verfahren zur Herstellung eines Targets für die physikalische Dampfphasenabscheidung, insbesondere eines Targets nach wenigstens einem der vorangehenden Ansprüche, wobei in Form eines Pulvers vorliegendes Tantaldiborid (TaB₂) und in Form eines Pulvers vorliegendes Wolframborid - sowie gegebenenfalls pulverförmiger Kohlenstoff, falls dieser nicht als Verunreinigung vorliegt - gemischt und gegebenenfalls mechanisch gemahlen werden und der so hergestellte Pulveransatz in einem formgebenden Werkzeug mittels Heißpressen oder Spark-Plasma-Sintern (SPS) verdichtet wird, **dadurch gekennzeichnet, dass** der Pulveransatz besteht aus:
- 95 mol% aus einer Mischung von Tantaldiborid (TaB₂) und Wolframborid
- und 0,01 mol% bis 5 mol% Kohlenstoff (C) wobei in Bezug auf die metallische Reinheit die Summe aus der Mischung von Tantaldiborid (TaB₂) und Wolframborid und dem Kohlenstoff (C) wenigstens 99,8 mol% beträgt,
und dass das Heißpressen oder Spark-Plasma-Sintern (SPS) mit einer Temperatur von mindestens 1750 °C, bevorzugt mindestens 1850 °C, besonders bevorzugt mindestens 1950 °C erfolgt.

10. Verfahren nach dem vorangehenden Anspruch, wobei das Heißpressen oder Spark-Plasma-Sintern (SPS) bei einem Druck von mindestens 20 MPa, bevorzugt mindestens 30 MPa erfolgt.

11. Verfahren nach wenigstens einem der vorangehenden Ansprüche, wobei das Heißpressen oder Spark-Plasma-Sintern (SPS) in einem Vakuum oder in einer inerten Schutzgasatmosphäre erfolgt.

12. Verwendung eines Targets nach wenigstens einem der Ansprüche 1 bis 8 in einem physikalischen Gasphasen-Abscheide-Verfahren (PVD) zur Abscheidung von Dünnschichten auf einem Substrat.

## Claims

1. Target for physical vapour deposition with the following chemical composition:
- at least 95 mol% of a mixture of at least two of the following compounds: tantalum diboride (TaB₂) and/or tungsten boride and/or mixed phases of tantalum diboride (TaB₂) and tungsten boride
- 0.01 mol% to 5 mol% of carbon (C)
- in particular less than 0.01 mol% of borides other than tantalum diboride (TaB₂) and/or tungsten boride and/or mixed phases of tantalum diboride (TaB₂) and tungsten boride
wherein, in relation to metallic purity, the sum of the mixture of tantalum diboride (TaB₂) and/or tungsten boride and/or mixed phases of tantalum diboride (TaB₂) and tungsten boride and the carbon (C) is at least 99.8 mol%,
and with the following physical properties:
- a density greater than 90%, preferably greater than 95%, of the theoretical density of the chemical composition defined above
- a d50 value, as the average grain size, of grains of the mixture of tantalum diboride (TaB₂) and/or tungsten boride and/or mixed phases of tantalum diboride (TaB₂) and tungsten boride of less than 10 µm, preferably less than 3 µm.

2. Target according to claim 1, wherein the molecular ratio of tantalum (Ta) to tungsten (W) in the mixture of tantalum diboride (TaB₂) and/or tungsten boride and/or mixed phases of tantalum diboride (TaB₂) and tungsten boride lies in a range of from 1:99 to 99:1, preferably in a range of from 10:90 to 90:10.

3. Target according to at least one of the preceding claims, wherein the carbon (C) is present in the form of graphite.

4. Target according to at least one of the preceding claims, wherein only tantalum diboride (TaB₂) and/or tungsten boride and/or mixed phases of tantalum diboride (TaB₂) and tungsten boride are present in the form of radiographically identifiable phases.

5. Target according to at least one of the preceding claims, wherein the tantalum diboride (TaB₂) and/or tungsten boride and/or mixed phases of tantalum diboride (TaB₂) and tungsten boride are present homogeneously distributed in the target such that, if at least five different square or circular measurement areas, with a size of at least 1 mm² in each case, are selected, the average chemical composition determined on the surface of the respective measurement area does not deviate by more than 20%, preferably not by more than 10%, from an averaged chemical composition calculated from all of the selected measurement areas.

6. Target according to at least one of the preceding claims, wherein an isotropic structure without preferred crystallographic grain orientation is recognizable in a radiographic examination of the target, wherein an aspect ratio of grains of tantalum diboride (TaB₂) and/or tungsten boride and/or mixed phases of tantalum diboride (TaB₂) and tungsten boride is less than 1.5, preferably less than 1.2, particularly preferably substantially 1.

7. Target according to at least one of the preceding claims, wherein possibly present chemical elements other than tantalum (Ta), tungsten (W), boron (B) and carbon (C) are dissolved in the structure of the mixture of tantalum diboride (TaB₂) and/or tungsten boride and/or mixed phases of tantalum diboride (TaB₂) and tungsten boride and are not radiographically detectable as separate phases.

8. Target according to at least one of the preceding claims, wherein an HV30 Vickers hardness of the target is greater than 1800 HV30, preferably greater than 2300 HV30.

9. Method for producing a target for physical vapour deposition, in particular a target according to at least one of the preceding claims, wherein tantalum diboride (TaB₂) present in the form of a powder and tungsten boride present in the form of a powder - as well as, where appropriate, pulverulent carbon, unless it is present as an impurity - are mixed and, where appropriate, mechanically ground, and the thus-produced batch of powder is compacted in a shaping die by means of hot pressing or spark plasma sintering (SPS), **characterized in that** the batch of powder consists of:
- 95 mol% of a mixture of tantalum diboride (TaB₂) and tungsten boride
- and 0.01 mol% to 5 mol% of carbon (C) wherein, in relation to metallic purity, the sum of the mixture of tantalum diboride (TaB₂) and tungsten boride and the carbon (C) is at least 99.8 mol%,
and **in that** the hot pressing or spark plasma sintering (SPS) is effected at a temperature of at least 1750°C, preferably at least 1850°C, particularly preferably at least 1950°C.

10. Method according to the preceding claim, wherein the hot pressing or spark plasma sintering (SPS) is effected at a pressure of at least 20 MPa, preferably at least 30 MPa.

11. Method according to at least one of the preceding claims, wherein the hot pressing or spark plasma sintering (SPS) is effected in a vacuum or in an inert protective atmosphere.

12. Use of a target according to at least one of claims 1 to 8 in a physical vapour deposition (PVD) process for depositing thin films on a substrate.

## Revendications

1. Cible pour le dépôt physique en phase vapeur, avec une composition chimique suivante :
- au moins 95 % en moles d'un mélange d'au moins deux des composés suivants : diborure de tantale (TaB2) et/ou borure de tungstène et/ou de phases mixtes de diborure de tantale (TaB2) et de borure de tungstène,
- 0,01 % en moles à 5 % en moles de carbone (C),
- en particulier moins de 0,01 % en moles de borures autres que le diborure de tantale (TaB2) et/ou que le borure de tungstène et/ou que des phases mixtes de diborure de tantale (TaB2) et de borure de tungstène, dans laquelle, en ce qui concerne la pureté métallique, la somme du mélange de diborure de tantale (TaB₂) et/ou de borure de tungstène et/ou de phases mixtes de diborure de tantale (TaB₂) et de borure de tungstène et du carbone (C) s'élève à au moins 99,8 % en moles,
et avec des propriétés physiques suivantes :
- une densité supérieure à 90 %, de préférence supérieure à 95 %, de la densité théorique de la composition chimique définie plus haut,
- une valeur d50 en tant que taille de grain moyenne de grains du mélange de diborure de tantale (TaB₂) et/ou de borure de tungstène et/ou de phases mixtes de diborure de tantale (TaB₂) et de borure de tungstène inférieure à 10 µm, de manière préférée inférieure à 3 µm.

2. Cible selon la revendication 1, dans laquelle le rapport moléculaire du tantale (Ta) par rapport au tungstène (W) dans le mélange de diborure de tantale (TaB₂) et/ou de borure de tungstène et/ou de phases mixtes de diborure de tantale (TaB₂) et de borure de tungstène se situe dans une plage de 1:99 à 99:1, de manière préférée dans une plage de 10:90 à 90:10.

3. Cible selon au moins l'une quelconque des revendications précédentes, dans laquelle le carbone (C) est présent sous la forme de graphite.

4. Cible selon au moins l'une quelconque des revendications précédentes, dans laquelle du diborure de tantale (TaB₂) et/ou du borure de tungstène et/ou des phases mixtes de diborure de tantale (TaB₂) et de borure de tungstène seulement sont présents sous la forme de phases identifiables par radiographie.

5. Cible selon au moins l'une quelconque des revendications précédentes, dans laquelle le diborure de tantale (TaB₂) et/ou le borure de tungstène et/ou des phases mixtes de diborure de tantale (TaB₂) et de borure de tungstène sont présents dans la cible avec une répartition homogène de telle manière qu'en choisissant au moins cinq zones de mesure différentes carrées ou circulaires avec une grandeur de respectivement au moins 1 mm², la composition chimique moyenne déterminée sur la surface de la zone de mesure respective ne s'écarte pas plus de 20 %, de manière préférée pas plus de 10 %, d'une composition chimique moyenne calculée à partir de toutes les zones de mesure sélectionnées.

6. Cible selon au moins l'une quelconque des revendications précédentes, dans laquelle une structure isotrope sans orientation de grain cristallographique préférée peut être reconnue dans un examen par radiographie de la cible, dans laquelle un rapport d'aspect de grains de diborure de tantale (TaB₂) et/ou de borure de tungstène et/ou de phases mixtes de diborure de tantale (TaB₂) et de borure de tungstène est inférieur à 1,5, de manière préférée inférieur à 1,2, de manière particulièrement préférée est sensiblement de 1.

7. Cible selon au moins l'une quelconque des revendications précédentes, dans laquelle des éléments chimiques éventuellement présents autres que du tantale (Ta), du tungstène (W), du bore (B) et du carbone (C) sont dissous dans la structure du mélange de diborure de tantale (TaB₂) et/ou de borure de tungstène et/ou de phases mixtes de diborure de tantale (TaB₂) et de borure de tungstène et ne peuvent pas être détectés par radiographie en tant que phases séparées.

8. Cible selon au moins l'une quelconque des revendications précédentes, dans laquelle une dureté de Vickers HV30 de la cible est supérieure à 1800 HV30, de manière préférée est supérieure à 2300 HV30.

9. Procédé destiné à fabriquer une cible pour le dépôt physique en phase vapeur, en particulier d'une cible selon au moins l'une quelconque des revendications précédentes, dans lequel du diborure de tantale (TaB₂) présent sous la forme d'une poudre et du borure de tungstène présent sous la forme d'une poudre - ainsi qu'éventuellement du carbone pulvérulent si celui-ci n'est pas présent en tant qu'impureté - sont mélangés et sont éventuellement broyés mécaniquement et l'ébauche de poudre ainsi fabriquée est compressée dans un outil de façonnage au moyen d'un pressage à chaud ou d'un frittage flash (SPS), **caractérisé en ce que** l'ébauche de poudre est constituée :
- de 95 % en moles d'un mélange de diborure de tantale (TaB₂) et de borure de tungstène,
- et de 0,01 % en moles à 5 % en moles de carbone (C), dans lequel en ce qui concerne la pureté métallique, la somme du mélange de diborure de tantale (TaB₂) et de borure de tungstène et du carbone (C) s'élève à au moins 99,8 % en moles,
et que le pressage à chaud ou le frittage flash (SPS) est effectué à une température d'au moins 1750 °C, de manière préférée d'au moins 1850 °C, de manière particulièrement préférée d'au moins 1950 °C.

10. Procédé selon la revendication précédente, dans lequel le pressage à chaud ou le frittage flash (SPS) est effectué à une pression d'au moins 20 MPa, de manière préférée d'au moins 30 MPa.

11. Procédé selon au moins l'une quelconque des revendications précédentes, dans lequel le pressage à chaud ou le frittage flash (SPS) est effectué sous vide ou sous atmosphère inerte.

12. Utilisation d'une cible selon au moins l'une quelconque des revendications 1 à 8 dans un procédé de dépôt physique en phase gazeuse (PVD) destiné à déposer des couches fines sur un substrat.
